# EUROPÄISCHE PATENTSCHRIFT

(11) **EP 1 716 070 B1**
(45) Veröffentlichungstag und Bekanntmachung des Hinweises auf die Patenterteilung: **02.07.2008**
(21) Anmeldenummer: 04802963.1
(22) Anmeldetag: 20.12.2004
(51) Int. Cl.: B81B 3/00

(54) **MIKROMECHANISCHER SENSOR**
MICROMECHANICAL SENSOR
DETECTEUR MICROMECANIQUE

(30) Priorität: 11.02.2004 DE 102004006698
(43) Veröffentlichungstag der Anmeldung: 02.11.2006
(73) Patentinhaber: Robert Bosch GmbH, 70442 Stuttgart (DE)
(72) Erfinder: BAER, Hans-Peter, 72793 Pfullingen (DE); HOECHST, Arnim, 72076 Tuebingen (DE)
(86) Internationale Anmeldenummer: PCT/DE2004/002777
(87) Internationale Veröffentlichungsnummer: WO 2005/077815

(56) Entgegenhaltungen:
- WO-A-03/016203
- DE-A1- 10 052 419

## Beschreibung

Die Erfindung betrifft einen mikromechanischen Sensor und ein Verfahren zu dessen Herstellung.

In der WO 03/016203 A2 wird ein Verfahren zur Herstellung eines Halbleiterbauelements mit einem Halbleiterträger vorgeschlagen, bei welchem für die Ausbildung von frei tragenden Strukturen für ein Halbleiterbauelement eine großflächige poröse Membranschicht und eine Kavität unter der porösen Membranschicht erzeugt wird. Die Erfindung hat die Aufgabe, eine Membranbeschädigung bei der Herstellung oder bei regelmäßig auftretenden Anwendungsfällen zu vermeiden. Diese Aufgabe kann durch unterschiedliche Vorgehensweisen gelöst werden. Bei einer ersten Lösung erhält der Halbleiterträger im Membranbereich im Vergleich zur Kavität eine unterschiedliche Dotierung, womit sich unterschiedliche Porengrößen und/oder Porositäten herstellen lassen, was bei der Kavitätserzeugung für einen verbesserten Ätzgastransport genutzt werden kann. Die Aufgabe kann jedoch auch dadurch gelöst werden, dass im Membranbereich Mesoporen und im späteren Kavitätsbereich Nanoporen als Hilfsstrukturen erzeugt werden.

In der DE 100 52 419 A1 wird ein Verfahren zur Herstellung eines mikromechanischen Bauteils beschrieben. Dabei wird zunächst auf einem Substrat eine Hilfsschicht und eine mit wenigstens einem Ätzloch versehene Membranschicht aufgebracht. Anschließend wird eine Spacerschicht aufgebracht. Die Spacerschicht wird dann anisotrop zurückgeätzt, so dass in dem Ätzloch ein Spacer erzeugt wird, wodurch das Ätzloch verengt wird. Anschließend wird die Hilfsschicht durch das Ätzloch hindurch geätzt, so dass in der Hilfsschicht ein Hohlraum entsteht. Nachfolgend wird eine Verschlussschicht aufgebracht, wodurch der Hohlraum verschlossen wird.

Mikromechanische Sensoren mit einer Membran finden z.B. als Strahlungsdetektoren zur Messung einer Infrarot-Strahlung in Gassensoren oder als Drucksensoren Anwendung. Die mikromechanischen Membranen werden hierbei im Allgemeinen durch Ätzung einer Kaverne mittels Kaliumhydroxid (KOH) oder Tetramethyl-Ammonium-Hydroxid (TMAH) von der Rückseite des bearbeiteten Wafers bis zu einer dielektrischen Schicht hergestellt. Hierbei werden mehrere Sensoren in einem Wafer ausgebildet und nachfolgend durch Zersägen des Wafers vereinzelt.

Neuere Ansätze gehen von einer Ätzung einer Kaverne unter der dielektrischen Schicht von der Wafervorderseite aus. Hierzu wird die Schicht perforiert, um dem Ätzmedium, z.B. Chlortrifluorid (CIF3), Zugang zum Substratmaterial zu verschaffen.

Bedingt durch die von der Perforation ausgehenden Unterätzung ist die Ätzfront der Kaverne jedoch nicht glatt, sondern weist Spitzen auf. Die Membran wird während des Ätzvorgangs unter Zugspannung gesetzt, um eine Aufwölbung zu vermeiden. An den Spitzen in der Ätzfront erhöht sich die Spannung erheblich, was zu Rissen in der Membran führen kann. Die Ausbildung der lokalen Spannungsspitzen kann hierbei während des Ätzprozesses insbesondere wegen der technisch bedingten Schwankungen kaum reguliert werden. Hierdurch können bei der Herstellung Beschädigungen auftreten und ein erheblicher Teil der hergestellten Sensoren defekt sein.

Der erfindungsgemäße mikromechanische Sensor und das Verfahren zu seiner Herstellung weisen demgegenüber insbesondere den Vorteil auf, dass die Membraneinspannung nicht mehr vom Kavernenätzprozess mit seinen technisch bedingten Schwankungen abhängig ist.

Weiterhin kann die Membraneinspannung durch das Layout der Anbindungsebene der äußeren Oxidschicht festgelegt werden. Erfindungsgemäß wird durch ein LOCOS (local oxidation of silicon) - Verfahren eine - vorzugsweise thermische - Oxidschicht ausgebildet, die nachfolgend zur Einspannung der während des Ätzprozesses gebildeten Membran dient. Hierdurch können nahezu beliebige Membranformen ausgebildet werden, z.B. kreisrund, aber auch rechtwinklig, z.B. quadratisch.

Durch das erfindungsgemäß angewendete LOCOS-Verfahren liegt die Membran in vertikaler Richtung im Bereich der dickeren äußeren Oxidschicht, d.h. zwischen der Oberseite und der Unterseite der äußeren Oxidschicht. Es erfolgt somit eine symmetrische Spannungseinwirkung auf die Membran während des Ätzvorgangs der Kaverne. Diese mittige Aufhängung bewirkt bereits eine gleichmäßigere Spannungseinleitung in die Membran; es können weiterhin vorteilhafterweise im Aufhängungsbereich der Membran relativ flache Oxidflanken ausgebildet werden, die zur Membran hin keilförmig bzw. dreickig unter einem spitzen Winkel zulaufen, wodurch eine besonders gleichmäßige und membranschonende Spannungseinleitung bewirkt wird, so dass während des Ätzvorganges eine Rissbildung - zumindest weitgehend - vermieden wird.

Die Membran ist durch ihre mittlere Position in dem fertig gestellten Sensor erfindungsgemäß auch geschützter angeordnet als bei der Ausbildung auf der Oberseite des Sensors, wie es bei herkömmlichen Ätztechniken in der Regel der Fall ist.

Der Erfindung liegt hierbei die überraschende Erkenntnis zugrunde, dass bisher nur zur Ausbildung integrierter Schaltungen verwendete LOCOS-Verfahren auch Vorteile für eine zusätzliche Ausbildung mikromechanischer Membranen bieten.

Somit werden erfindungsgemäß ein sicheres, mit relativ geringem Aufwand und kostengünstiges Herstellungsverfahren mit relativ geringem Ausschuss und ein weitgehend beschädigungsfreier, kostengünstig herstellbarer Sensor mit geschützt angeordneter Membran zur Verfügung gestellt.

Durch nachfolgendes Verschließen der Perforationslöcher in der Membran kann z.B. ein Drucksensor hergestellt werden. Weiterhin kann ein infrarot-Detektor zum Einsatz in einem Gassensor hergestellt werden, indem eine Thermopile-Struktur und eine Absorberschicht aufgetragen werden.

Das Substrat ist vorteilhafterweise aus Silizium gebildet, wobei ein Silizium selektiv ätzendes Ätzgas, z.B. CIF3, verwendet wird.

Die Erfindung wird im Folgenden anhand der beiliegenden Zeichnungen an einer Ausführungsform näher erläutert. Die Figuren zeigen aufeinander folgende Schritte eines erfindungsgemäßen Verfahrens zur Herstellung eines erfindungsgemäßen mikromechanischen Sensors. Es zeigen:
- Fig. 1: einen ersten Schritt des erfindungsgemäßen Herstellungsverfahrens nach Ausbilden einer Siliziumdioxid-Schicht und Siliziumnitrid-Schicht auf einem Substrat;
- Fig. 2: einen nachfolgenden Schritt nach photolithographischer Strukturierung;
- Fig. 3: einen nachfolgenden Schritt nach einer lokalen Oxidation;
- Fig. 4: einen durch einen nachfolgenden Schritt der Kavernenätzung hergestellten erfindungsgemäßen Sensor.
- Fig. 5: einen Infrarot-Detektor als Beispiel eines erfindungsgemäßen Sensors.

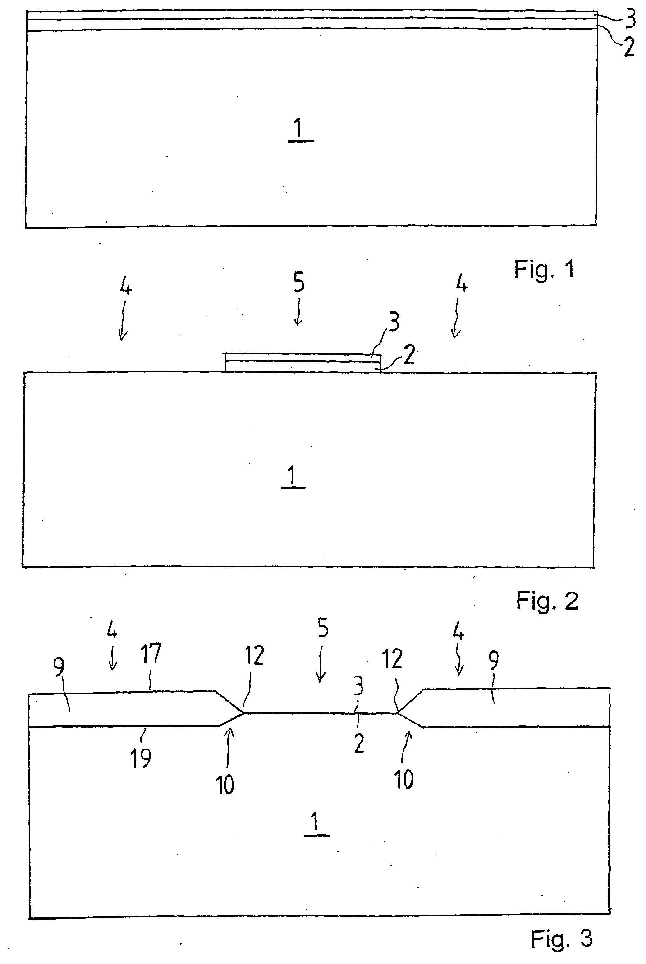

Auf einem Substrat 1 aus Silizium oder Silizium-Germanium wird durch thermische Oxidation eine dünne erste Siliziumdioxid (SiO2)-Schicht 2 ausgebildet, auf die nachfolgend durch einen CVD (chemical vapor deposition)-Prozess gemäß Fig. 1 eine Siliziumnitrid (Si3N4)-Schicht 3 abgeschieden wird.

Nachfolgend werden durch eine an sich bekannte photolithographische Strukturierung in einem lateral äußeren Bereich 4 um einen inneren Membranbereich 5 herum gemäß Fig. 2 die erste Siliziumdioxid-Schicht 2 und die Siliziumnitrid-Schicht 3 entfernt. Der innere Bereich 4 kann hierbei grundsätzlich eine beliebige Form, z.B. kreisrund oder rechtwinklig, annehmen.

Nachfolgend wird gemäß Fig. 3 durch eine lokale Oxidation eine LOCOS-Struktur ausgebildet, indem in den äußeren Bereichen 4 durch thermische Oxidation eine dickere zweite Siliziumdioxid-Schicht 9 ausgebildet wird. In Fig. 3 ist die die spätere Membran bildende Membranschicht aus den Schichten 2, 3 vereinfacht mit relativ geringer Dicke dargestellt. Die Siliziumnitrid-Schicht 3 verhindert im Membranbereich 5 die Oxidation des Substrates 1, so dass die zweite Siliziumdioxid-Schicht 9 hier nicht ausgebildet wird. Die zweite Siliziumdioxid-Schicht 9 ragt gegenüber dem Membranbereich 5 auch teilweise nach unten in das Substrat 1 hinein. Hierdurch kann eine relativ flache LOCOS-Struktur ausgebildet werden, bei der die aus den Schichten 2 und 3 gebildete Membranschicht in einem in vertikaler Richtung mittleren Bereich der dickeren zweiten Siliziumdioxid-Schicht 9 zwischen deren Oberseite 17 und deren Unterseite 19 angeordnet sind. Es bildet sich in der zweiten Siliziumdioxid-Schicht 9 zwischen dem äußeren Bereich 4 und dem Membranbereich 5 ein Aufhängungsbereich 10 aus, der sich im Querschnitt verjüngt und unter einem spitzen Winkel, z.B. keilförmig, dreieckig oder "vogelschnabelartig", zu einem Anbindungspunkt 12 zuläuft.

Aus der Membranschicht 2, 3 kann optional in Anschluss an Fig. 3 die Nitridschicht 3 durch ein nasschemisches Verfahren entfernt werden. Die Membranschicht kann somit durch die Nitridschicht 3 und die innere Oxidschicht 2 oder nur durch die innere Oxidschicht 2 gebildet sein; grundsätzlich ist auch anschließend die zusätzliche Abscheidung von weiteren Schichten auf der innere Oxidschicht 2 möglich, um eine geeignete Membranschicht auszubilden.

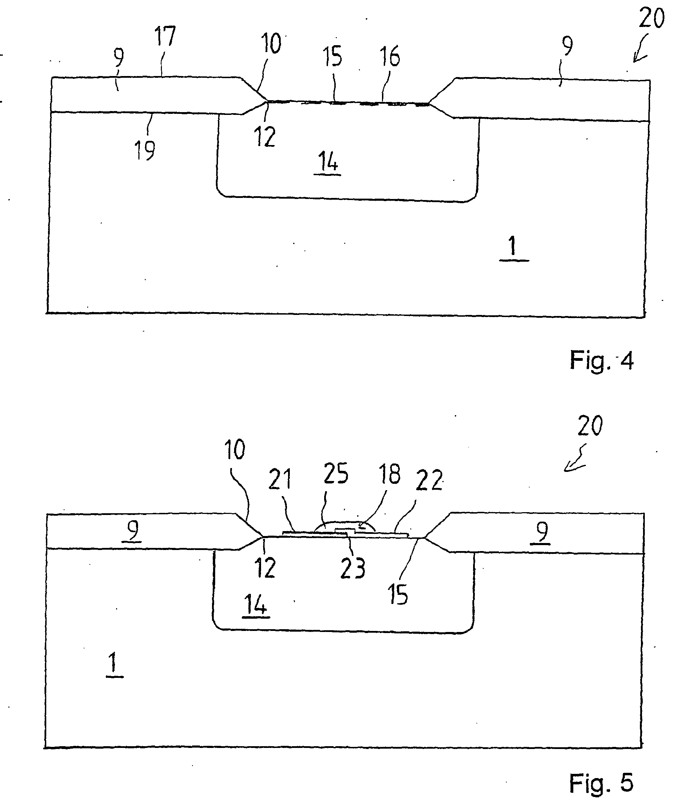

Nachfolgend wird unterhalb des Membranbereiches 5 eine Kaverne 14 geätzt. Hierzu kann wird in an sich bekannter Weise die durch die Schichten 2, 3 gebildete Membran 15 zunächst durch Ausbildung von Perforationslöchern 16 perforiert, die zur Zuführung eines Ätzgases, z.B. CIF3 (Chlortrifluorid) dienen, das siliziumselektiv ätzt und die Membran 15 und die zweite Siliziumdioxid-Schicht 9 schont. Die Kaverne 14 kann in Abhängigkeit der Ätzparameter, insbesondere Ätzdauer, Ätzdruck und Ätztemperatur, in geeigneter Weise ausgebildet werden und erstreckt sich gemäß Fig. 4 über den Aufhängungsbereich 10 bis etwas unterhalb der zweiten Siliziumdioxid-Schicht 9. Somit wird eine freitragende Membran 15 ausgebildet, die in spitzen Anbindungspunkten 12 an der zweiten Siliziumdioxid-Schicht 9 aufgehängt ist.

Nachfolgend können weitere Schichten aufgetragen werden, um einen gewünschten Sensor herzustellen. Zur Ausbildung eines Infrarotdetektors 20 für Infrarotstrahlung, der z.B. in einem Gassensor zur Messung von Gaskonzentrationen verwendet werden kann, können auf die Membran 15 nachfolgend zunächst eine Thermopile-Struktur 18 mit Leiterbahnbereichen 21, 22 aus unterschiedlichen leitfähigen Materialien, z.B. einem Metall und Polysilizium, aufgetragen werden, die sich in einem Kontaktbereich 23 berühren, z.B. überlappen. Nachfolgen kann eine Absorberschicht 25 aufgetragen werden, so dass ein Thermopilesensor 20 ausgebildet wird, in dem die einfallende infrarote Strahlung zu einer Erwärmung der Absorberschicht 25 führt, die als Thermospannung von der Thermopilestruktur der beiden Leiterbahnen gemessen werden kann.

Alternativ hierzu können auch andere mikromechanische Sensoren, z.B. in Fig. 4 nach Verschließen der Perforationslöcher 16 z.B. durch Sputtern ein Drucksensor 20, ausgebildet werden.

Auf einem Wafer werden mehrere Sensoren 20 hergestellt und nachfolgend durch Aussägen vereinzelt.

## Patentansprüche

1. Mikromechanischer Sensor, der mindestens aufweist:
ein Substrat (1),
eine in einem lateral äußeren Bereich (4) in dem Substrat (1) ausgebildete äußere Oxidschicht (9),
eine in einem lateral inneren Membranbereich (5)ausgebildete Membran (15) mit mehreren Perforationslöchern (16),
eine in das Substrat (1) unterhalb der Membran (15) geätzte Kaverne (14),
wobei die Membran (15) in einem Aufhängungsbereich (10) der äußeren Oxidschicht (9) aufgehängt ist, der sich zu Anbindungspunkten (12) der Membran (15) hin verjüngt, und
die Membran (15) in ihrer vertikalen Höhe zwischen einer Oberseite (17) und einer Unterseite (19) der äußeren Oxidschicht (9) angeordnet ist,
wobei die äußere Oxidschicht (9) sich in dem Aufhängungsbereich (10) zu den Befestigungspunkten (12) hin unter einem spitzen Winkel, z.B. keilförmig oder dreieckförmig, verjüngt.

2. Mikromechanischer Sensor nach Anspruch 1, **dadurch gekennzeichnet, dass** die Kaverne (14) sich bis unter die äußere Oxidschicht (9) außerhalb des Aufhängungsbereichs (10) erstreckt.

3. Mikromechanischer Sensor nach einem der vorherigen Ansprüche, **dadurch gekennzeichnet, dass** die Membran (15) eine innere Oxidschicht (2) und eine auf der inneren Oxidschicht (2) ausgebildete Nitridschicht (3) aufweist.

4. Mikromechanischer Sensor nach einem der Ansprüche 1 bis 2, **dadurch gekennzeichnet, dass** die Membran (15) aus einer inneren Oxidschicht (2) gebildet ist

5. Mikromechanischer Sensor nach einem der vorherigen Ansprüche, **dadurch gekennzeichnet, dass** die Membran (15) rechteckig oder rund ist.

6. Mikromechanischer Sensor nach einem der vorherigen Ansprüche, **dadurch gekennzeichnet, dass** die Membran (15) etwa in einer mittleren vertikalen Höhe der äußeren Oxidschicht (9) angeordnet ist.

7. Verfahren zum Herstellen eines mikromechanischen Sensors (20), mit mindestens folgenden Schritten:
Ausbildung einer inneren Oxidschicht (2) auf einem Substrat (1);
Ausbilden einer Nitridschicht (3) auf der inneren Oxidschicht (2);
Strukturieren der inneren Oxidschicht (2) und der Nitridschicht (3) derartig, dass die innere Oxidschicht (2) und die Nitridschicht (3) in einem lateral mittleren Membranbereich (5) erhalten bleibt und in einem den mittleren Membranbereich (5) umgebenden äußeren Bereich (4) entfernt wird;
lokales Oxidieren des Substrates (1) in dem äußeren Bereich (4) unter Ausbildung einer äußeren Oxidschicht (9), die eine größere Dicke als die Gesamtdicke der aus der inneren Oxidschicht (2) und der Nitridschicht (3) gebildeten Membranschicht aufweist;
Ausbilden von Perforationslöchern (16) in der Membranschicht (2; 2,3) in dem Membranbereich (5);
Zuführen eines das Substrat (1) selektiv ätzenden Ätzgases durch die Perforationslöcher (16) und Ausbilden einer Kaverne (14) in dem Substrat (1) und einer Membran (15) oberhalb der Kaverne (14);
wobei die Membran (15) in ihrer vertikalen Höhe zwischen einer Oberseite (17) und einer Unterseite (19) der äußeren Oxidschicht (9) angeordnet und in einem sich zu der Membran (15) hin verjüngenden Aufhängungsbereich (10) der äußeren Oxidschicht (9) aufgehängt ist,
wobei die äußere Oxidschicht (9) sich in dem Aufhängungsbereich (10) zu den Befestigungspunkten (12) hin unter einem spitzen Winkel, z.B. keilförmig oder dreieckförmig, verjüngt.

8. Verfahren nach Anspruch 7, **dadurch gekennzeichnet, dass** vor dem Ausbilden der Perforationslöcher (16) die Nitridschicht (3) aus der Membranschicht (2,3) entfernt wird.

9. Verfahren nach Anspruch 8, **dadurch gekennzeichnet, dass** die Nitridschicht (3) aus der Membranschicht (2,3) durch ein nasschemisches Verfahren entfernt wird.

10. Verfahren nach einem der Ansprüche 7 bis 9, **dadurch gekennzeichnet, dass** während des Ätzens der Kaverne (14) eine Zugspannung auf die äußere Oxidschicht (9) ausgeübt wird.

11. Verfahren nach einem der Ansprüche 7 bis 10, **dadurch gekennzeichnet, dass** die Kaverne (14) bis unter die äußere Oxidschicht (9) außerhalb des Aufhängungsbereiches (10) ausgebildet wird.

12. Verfahren nach einem der Ansprüche 7 bis 11, **dadurch gekennzeichnet, dass** auf der Membran (15) eine Thermopile-Struktur (18) mit mindestens zwei in einem Kontaktbereich (23) kontaktierten Leiterbahnbereichen (21, 22) und eine Absorberschicht (25) zur Absorption von Infrarot-Strahlung aufgetragen werden.

13. Verfahren nach einem der Ansprüche 7 bis 12, **dadurch gekennzeichnet, dass** die Perforationslöcher (16) nachfolgend verschlossen werden. 14.Verfahren nach einem der Ansprüche 7 bis 13, **dadurch gekennzeichnet, dass** eine rechteckige oder runde Membran (15) ausgebildet wird.

## Claims

1. Micromechanical sensor, at least comprising:
a substrate (1),
an outer oxide layer (9) formed in a laterally outer region (4) in the substrate (1),
a membrane (15) formed in a laterally inner membrane region (5) and having a plurality of perforation holes (16),
a cavity (14) etched into the substrate (1) below the membrane (15),
wherein the membrane (15) is suspended in a suspension region (10) of the outer oxide layer (9), said suspension region tapering towards linking points (12) of the membrane (15), and
the membrane (15) is arranged in its vertical level between a top side (17) and an underside (19) of the outer oxide layer (9),
wherein the outer oxide layer (9) tapers in the suspension region (10) towards the fixing points (12) at an acute angle, e.g. in wedge-shaped or triangular fashion.

2. Micromechanical sensor according to Claim 1, **characterized in that** the cavity (14) extends as far as the outer oxide layer (9) outside the suspension region (10).

3. Micromechanical sensor according to any of the preceding claims, **characterized in that** the membrane (15) has an inner oxide layer (2) and a nitride layer (3) formed on the inner oxide layer (2).

4. Micromechanical sensor according to either of Claims 1 and 2, **characterized in that** the membrane (15) is formed from an inner oxide layer (2).

5. Micromechanical sensor according to any of the preceding claims, **characterized in that** the membrane (15) is rectangular or round.

6. Micromechanical sensor according to any of the preceding claims, **characterized in that** the membrane (15) is arranged approximately in a central vertical level of the outer oxide layer (9).

7. Method for producing a micromechanical sensor (20), comprising at least the following steps:
forming an inner oxide layer (2) on a substrate (1);
forming a nitride layer (3) on the inner oxide layer (2);
patterning the inner oxide layer (2) and the nitride layer (3) in such a way that the inner oxide layer (2) and the nitride layer (3) are retained in a laterally central membrane region (5) and removed in an outer region (4) surrounding the central membrane region (5);
local oxidation of the substrate (1) in the outer region (4) to form an outer oxide layer (9), which has a thickness greater than the total thickness of the membrane layer formed from the inner oxide layer (2) and the nitride layer (3);
forming perforation holes (16) in the membrane layer (2; 2, 3) in the membrane region (5);
feeding an etching gas that selectively etches the substrate (1) through the perforation holes (16), and
forming a cavity (14) in the substrate (1) and a membrane (15) above the cavity (14);
wherein the membrane (15) is arranged in its vertical level between a top side (17) and an underside (19) of the outer oxide layer (9) and is suspended in a suspension region (10) of the outer oxide layer (9), said suspension region tapering towards the membrane (15),
wherein the outer oxide layer (9) tapers in the suspension region (10) towards the fixing points (12) at an acute angle, e.g. in wedge-shaped or triangular fashion.

8. Method according to Claim 7, **characterized in that** prior to forming the perforation holes (16), the nitride layer (3) is removed from the membrane layer (2, 3).

9. Method according to Claim 8, **characterized in that** the nitride layer (3) is removed from the membrane layer (2, 3) by means of a wet-chemical method.

10. Method according to any of Claims 7 to 9, **characterized in that** a tensile stress is exerted on the outer oxide layer (9) during the etching of the cavity (14).

11. Method according to any of Claims 7 to 10, **characterized in that** the cavity (14) is formed as far as below the outer oxide layer (9) outside the suspension region (10).

12. Method according to any of Claims 7 to 11, **characterized in that** a thermopile structure (18) with at least two conductor track regions (21, 22) that are contact-connected in a contact region (23) and an absorber layer (25) for absorbing infrared radiation are applied on the membrane (15).

13. Method according to any of Claims 7 to 12, **characterized in that** the perforation holes (16) are subsequently closed off.

14. Method according to any of Claims 7 to 13, **characterized in that** a rectangular or round membrane (15) is formed.

## Revendications

1. Capteur micromécanique ayant au moins :
- un substrat (1),
- une couche extérieure, d'oxyde (9), réalisée dans une zone extérieure (4) latérale du substrat (1),
- une membrane (15) avec plusieurs orifices de perforation (16) réalisés dans une zone de membrane (5) latérale intérieure,
- une caverne (14) gravée dans le substrat (1) sous la membrane (15),
- la membrane (15) étant suspendue dans une zone de suspension (10) de la couche extérieure d'oxyde (9) qui diminue vers les points d'attache (12) de la membrane (15) et
- la membrane (15) est installée dans sa direction verticale entre un côté supérieur (17) et un côté inférieur (19) de la couche extérieure d'oxyde (9),
- la couche extérieure d'oxyde (9) se rétrécissant dans la zone d'accrochage (10) pour former un point de fixation (12) sous un angle aigu, par exemple en forme de coin ou de triangle.

2. Capteur micromécanique selon la revendication 1,
**caractérisé en ce que**
la caverne (14) se développe au-delà de la zone de suspension (10) jusque sous la couche extérieure d'oxyde (9).

3. Capteur micromécanique selon l'une des revendications précédentes,
**caractérisé en ce que**
la membrane (15) comporte une couche intérieure d'oxyde (2) et une couche de nitrure (3) réalisée sur la couche intérieure d'oxyde (2).

4. Capteur micromécanique selon l'une des revendications 1 et 2,
**caractérisé en ce que**
la membrane (15) est réalisée par une couche intérieure d'oxyde (2).

5. Capteur micromécanique selon l'une des revendications précédentes,
**caractérisé en ce que**
la membrane (15) est rectangulaire ou ronde.

6. Capteur micromécanique selon l'une des revendications précédentes,
**caractérisé en ce que**
la membrane (15) est installée sensiblement à la verticale centrale de la couche extérieure d'oxyde (9).

7. Procédé de fabrication d'un capteur micromécanique (20) comprenant au moins les étapes suivantes :
- développement d'une couche intérieure d'oxyde (2) sur un substrat (1),
- développement d'une couche de nitrure (3) sur la couche intérieure d'oxyde (2),
- mise en structure de la couche intérieure d'oxyde (2) et de la couche de nitrure (3) de façon que la couche intérieure d'oxyde (2) et la couche de nitrure (3) restent dans une zone latérale médiane de la membrane (5) et soient éloignées d'une zone extérieure (4) entourant la zone médiane (5) de la membrane,
- oxydation locale du substrat (1) dans la zone extérieure (4) en formant une couche extérieure d'oxyde (9) ayant une épaisseur plus importante que l'épaisseur totale de la couche formant la membrane composée de la couche intérieure d'oxyde (2) et la couche de nitrure (3),
- développement d'orifices de perforation (16) dans la couche de membrane (2 ; 2, 3) dans la zone de membrane (5),
- fourniture d'un gaz de gravure à action de gravure sélective sur le substrat (1) à travers les orifices de perforation (16) et formation d'une caverne (14) dans le substrat (1) et d'une membrane (15) au-dessus de la caverne (14),
la membrane (15) se situant dans sa direction verticale entre le côté supérieur (17) et le côté inférieur (19) de la couche extérieure d'oxyde (9) et elle est suspendue dans une zone de suspension (10) de la couche extérieure d'oxyde (9) qui va en diminuant vers la membrane (15),
la couche extérieure d'oxyde (9) allant en diminuant dans la zone de suspension (10) vers les points de fixation (12) suivant un angle obtus, par exemple suivant une forme de coin ou de triangle.

8. Procédé selon la revendication 7,
**caractérisé en ce qu'**
avant de développer les orifices de perforation (16) on enlève la couche de nitrure (3) de la couche de membrane (2, 3).

9. Procédé selon la revendication 8,
**caractérisé en ce qu'**
on enlève la couche de nitrure (3) de la couche de membrane (2, 3) par un procédé de chimie par voie humide.

10. Procédé selon l'une des revendications 7 à 9,
**caractérisé en ce que**
pendant la gravure de la caverne (14) on exerce une traction sur la couche externe d'oxyde (9).

11. Procédé selon l'une des revendications 7 à 10,
**caractérisé en ce qu'**
on développe la caverne (14) jusque sous la couche extérieure d'oxyde (9) au-delà de la zone de suspension (10).

12. Procédé selon l'une des revendications 7 à 11,
**caractérisé en ce qu'**
on applique sur la membrane (15), une structure de thermopile (18) avec au moins deux zones de chemins conducteurs (21, 22) en contact dans une zone de contact (23) et une couche d'absorption (25) pour absorber le rayonnement infrarouge.

13. Procédé selon l'une des revendications 7 à 12,
**caractérisé en ce qu'**
ensuite on ferme les orifices de perforation (16).

14. Procédé selon l'une des revendications 7 à 13,
**caractérisé en ce qu'**
on forme une membrane (15) rectangulaire ou ronde.
